# EUROPEAN PATENT SPECIFICATION

(11) **EP 1 557 560 B1**
(45) Date of publication and mention of the grant of the patent: **17.10.2007**
(21) Application number: 04425035.5
(22) Date of filing: 22.01.2004
(51) Int. Cl.: F02P 3/055, H03K 17/567

(54) **Circuit for dynamic control of a power transistor in applications for high voltage**
Dynamische Steuerung eines Leistungstransistors bei Hochspannungsanwendungen
Contrôle dynamique d'un transistor de puissance conçu pour les applications haute-tension

(43) Date of publication of application: 27.07.2005
(73) Proprietor: STMicroelectronics S.r.l., 20041 Agrate Brianza (Milano) (IT)
(72) Inventor: Torres, Antonino, 95125 Catania (IT); Patti, Davide, 95122 Catania (IT)
(74) Representative: Ferrari, Barbara

(56) References cited:
- EP-A- 0 730 347
- US-B1- 6 283 104
- PATENT ABSTRACTS OF JAPAN vol. 1997, no. 11, 28 November 1997 (1997-11-28) & JP 9 177647 A (HITACHI LTD; HITACHI CAR ENG CO LTD), 11 July 1997 (1997-07-11)

## Description

### Field of application

The present invention relates to a circuit for dynamic control of a power transistor in applications for high voltage.

More specifically, the invention relates to a circuit for dynamic control of a power transistor in applications for high voltage comprising a power transistor with a conduction terminal connected to a load and a control terminal receiving a driving signal from a driver block activated by a trigger signal, received on a circuit input terminal. The invention particularly relates, but not exclusively, to a circuit for dynamic control of a power transistor of the IGBT type, in applications for high voltage, and the following description is made with reference to this field of application for convenience of illustration only.

### Prior art

Microprocessor-driven control systems for electronic ignition are known. These systems, in their most general form, allow a spark to be generated on a sparking plug associated to an internal-combustion engine.

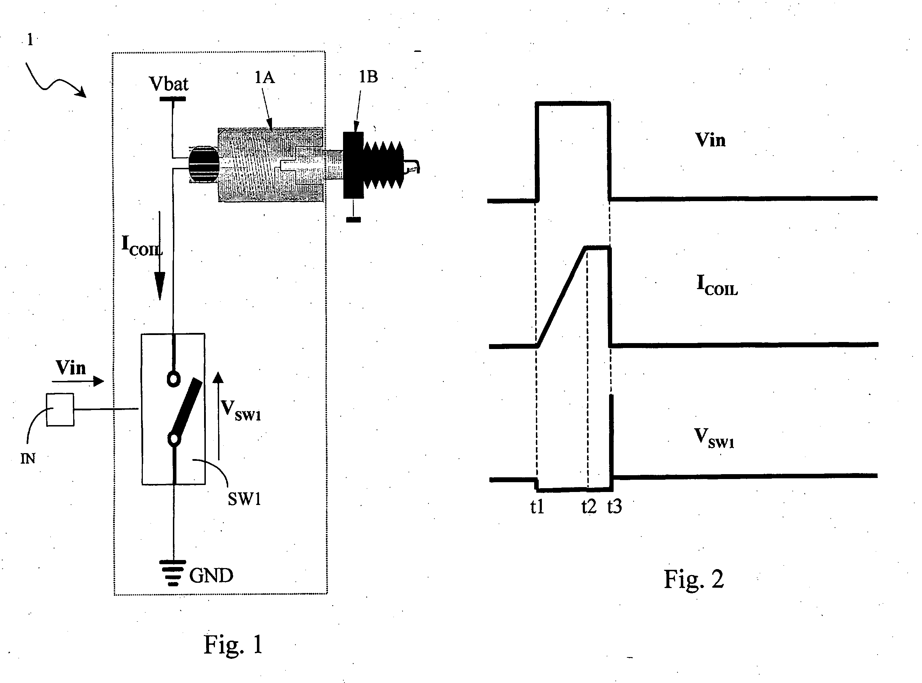

In particular, a control circuit for electronic ignition, globally indicated with 1, is schematically shown in figure 1.

The control circuit 1 receives a trigger pulse Vin produced for example by a microprocessor (not shown in the figure) and applied to an input terminal IN connected to a driving terminal of an operated switch SW1.

The switch SW1 is inserted between a first voltage reference, particularly a supply voltage reference Vbat, and a second voltage reference, particularly a ground GND.

The switch SW1 is also connected to a primary coil winding 1A, connected in turn to said supply voltage reference Vbat and to an ignition sparking plug 1B.

At the ends of the switch SW1, driven by the trigger pulse Vin, there is a voltage value V_{SW1}.

The trigger pulse Vin determines the charging time of the primary coil winding 1A, closing the switch SW 1 through which a current I_{COIL} flows, as shown in figure 2.

In particular, for a time t<t1, the trigger signal Vin has a low value and, consequently, the switch SW1 is open, keeping also the current value I_{COIL} low and the voltage V_{SW1} is equal to the voltage Vbatt.

For t=t1, the microprocessor brings the trigger signal Vin at a high value which, closing the switch SW1, allows the current I_{COIL} to flow in the coil winding 1A.

The trigger signal Vin is kept high until a time t3. In the interval t1<t<t3, in correspondence with the high value of the trigger signal Vin, the coil current I_{COIL} increases with a slope trend until it reaches a maximum value in correspondence with a time t2 being lower than t3, remaining thus at this value until the time t3.

Therefore, the trigger signal Vin goes back to the low state and it consequently opens the switch SW1. At this time t3, the voltage Vswi at the ends of the switch instantaneously reaches a high value. An overvoltage thus occurs on the primary coil winding 1A which, transferring to the secondary through the coil turn ratio, generates a spark on the sparking plug 1B.

An implementation of the control circuit 1 of figure 1, timed as described in figure 2, is shown in figure 3, wherein the switch SW1 is realised by means of a power element, particularly an IGBT transistor.

The control circuit 2 for electronic ignition receives on a first input terminal IN1 the trigger pulse Vin produced by a microprocessor not shown in the figure.

It also receives, on a second input terminal IN2, a reference voltage value Vref, produced by a convenient reference voltage generator 3.

The control circuit 2 comprises a power element, particularly an IGBT transistor TR1 used as switch, comprised between the supply voltage reference Vbat and the ground GND.

The transistor TR1 has a first conduction terminal, particularly the collector terminal C, coupled to a supply voltage reference Vbat by means of the coil 1A, a second conduction terminal, particularly the emitter terminal E, coupled to the ground GND by means of a sensing resistance Rsen, as well as a control terminal, particularly a gate terminal G1 connected, by means of a driver block 4, to the first input terminal of the control circuit 2.

The driver block 4 is also connected to the supply voltage reference Vbat.

The control circuit 2 also comprises a current limiting block 5 inserted between the control terminal G1 and the emitter terminal E of the transistor TR 1 and essentially comprising an operational amplifier OP1.

In particular, the operation amplifier OP1 is a fed-back non inverting amplifier having a non inverting input terminal (+) connected to the emitter terminal E, an inverting input terminal (-) connected to the reference voltage generator 3 and an output terminal connected to the control terminal G1 of the transistor TR1.

The coil current value Icoil is then limited by means of the comparator OP1 reading the drop at the ends of the sensing resistance Rsen, being proportional to the coil current Icoil, comparing it with the reference voltage Vref and conveniently biasing the control terminal G1 of the transistor TR1, in order not to exceed a predetermined maximum current value.

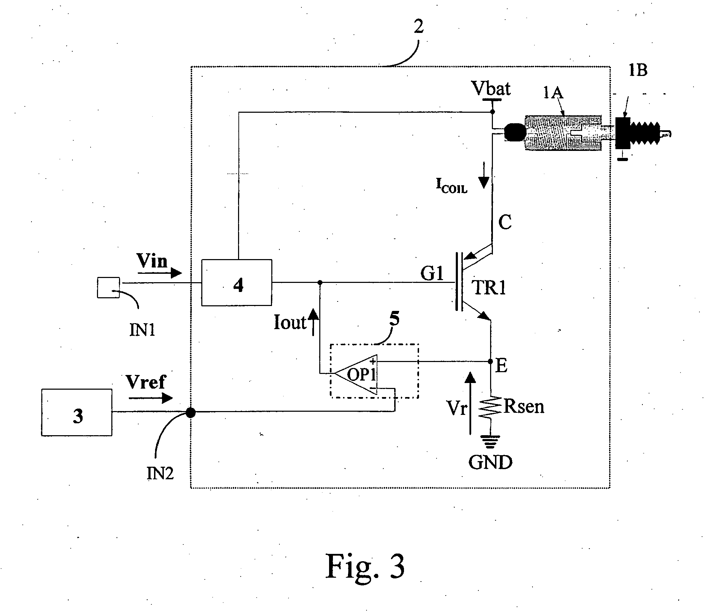

In practise, in order to stabilise a fed-back configuration as the one shown in figure 3, a convenient dynamic compensation mechanism must be provided.

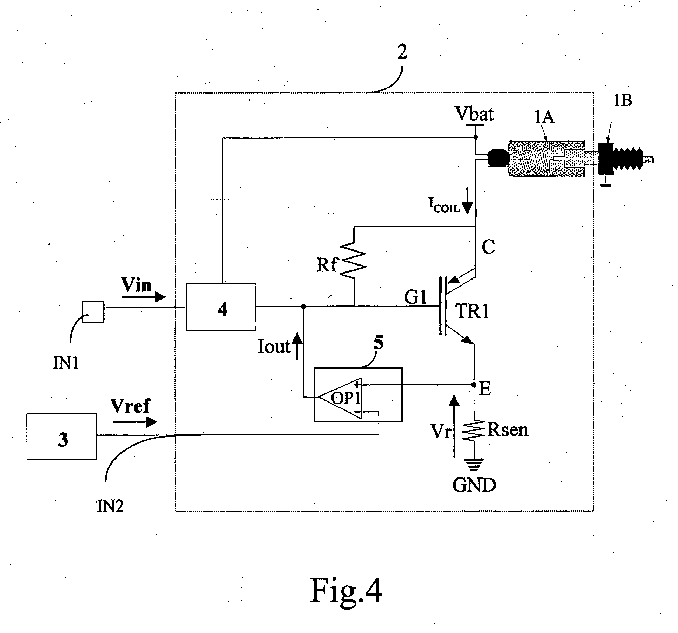

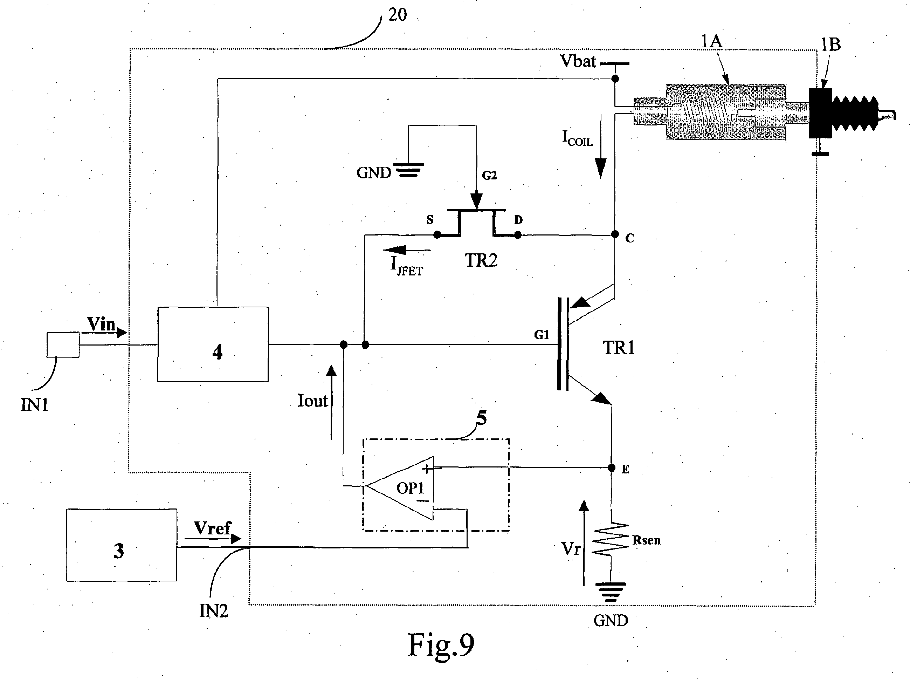

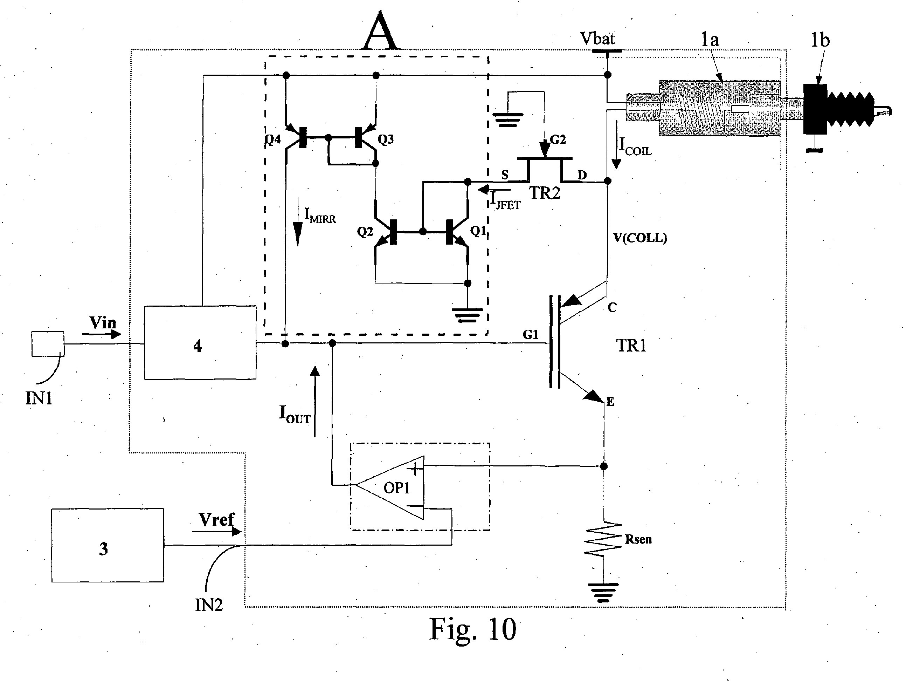

To this aim, it is known to use a compensation resistance Rf inserted between the collector terminal C and the control terminal G 1 of the transistor TR1, as schematically shown in figure 4.

Actually, this solution cannot be used in the case of a circuit which must operate at high voltage, as in the case of an electronic ignition application, wherein, in order to have a spark in the secondary, it is necessary that the voltage detected at the collector terminal C, upon the transistor TR1 turn-off by means of the trigger voltage Vin, reaches values of some hundreds of volts.

In fact, in this case, the resistance Rf prevents the voltage on the collector terminal C from reaching such a high desired value, since it would trigger, before reaching this value, a new turn-on of the IGBT power transistor TR1.

Also known from the European patent application published on September 4, 1993 under No. 0 730 347 in the name of Fuji Electric Cp., Ltd is a semiconductor device wherein an IGBT response speed and the circuit stability is controlled by the rate of change dVG/dt of the gate voltage VG, so that the current limitation operation in the IGBT is relaxed and it is possible to prevent sudden drop oscillation in a current.

The technical problem underlying the present invention is to provide a dynamic compensation circuit for a power transistor, like an IGBT transistor, having such structural and functional features as to be capable of operating at low voltage, overcoming the limits and/or drawbacks still affecting prior art circuits.

### Summary of the invention

The solution idea underlying the present invention is to use a JFET transistor integrated in the same power transistor structure, allowing a resistance with a non-linear feature to be integrated.

On the basis of this solution idea the technical problem is solved by a circuit as previously indicated and defined in the characterising part of claim 1.

The features and advantages of the device according to the invention will be apparent from the following description of an embodiment thereof given by way of indicative and non-limiting example with reference to the attached drawings.

### Brief description of the drawings

In these drawings:
- Figure 1 schematically shows a control circuit for an electronic ignition system, realised according to the prior art;
- Figure 2 schematically shows the trend in time of inner signals of said circuit of figure 1, according to the prior art;
- Figure 3 shows, in greater detail, an embodiment of said control circuit of figure 1, according to the prior art;
- Figure 4 shows, in greater detail, an alternative embodiment of said control circuit of figure 1, according to the prior art;

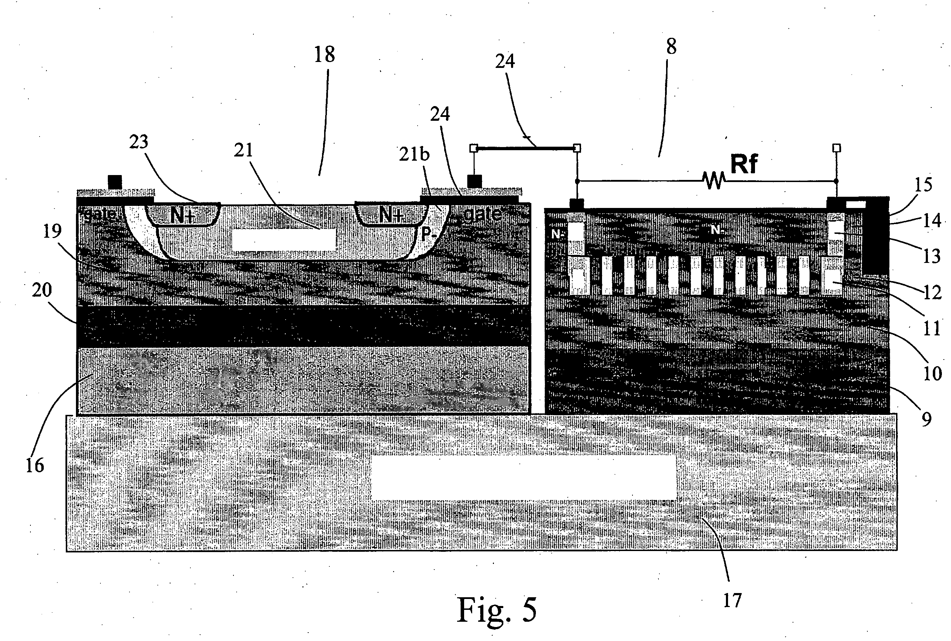

- Figure 5 schematically shows an integrated structure according to the present invention to realise a control circuit for an IGBT transistor using an integrated resistance realised in the ViPower technology;

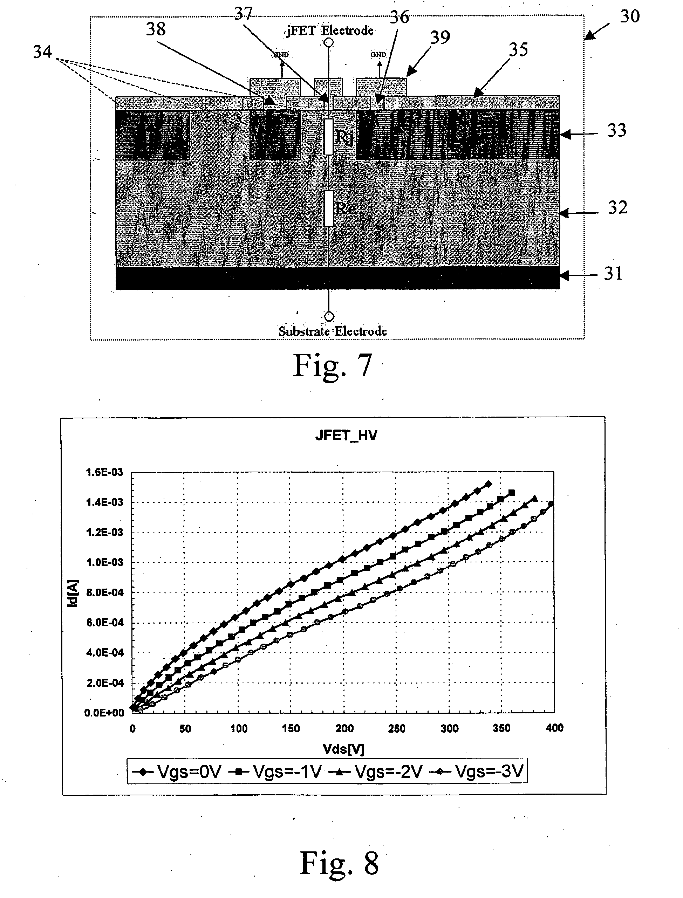

- Figure 6 shows the trend of the electric feature of said resistance of figure 5 according to the invention;
- Figure 7 schematically shows an integrated structure effective to implement a JFET transistor being integrated in the structure of said IGBT transistor, according to the invention;
- Figure 8 shows the trend of a typical curve of the JFET transistor of figure 7, according to the invention;

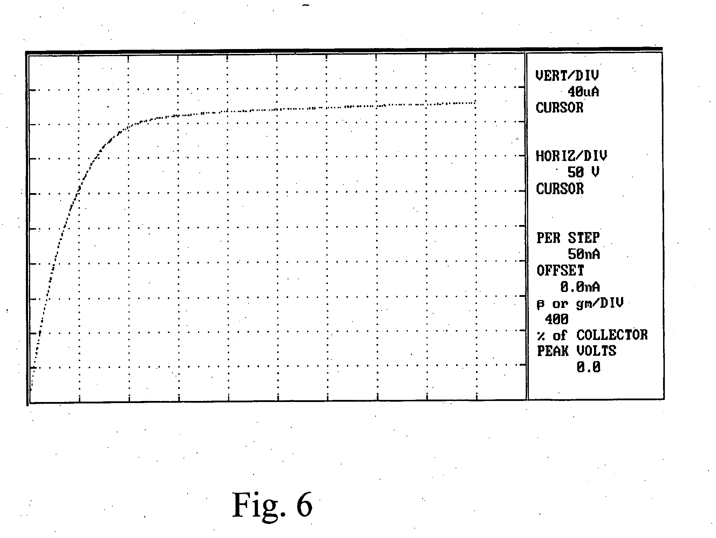

- Figure 9 shows a control circuit for a power transistor, for example an IGBT transistor realised according to the invention;
- Figure 10 shows an alternative embodiment of said control circuit of figure 9, according to the invention;

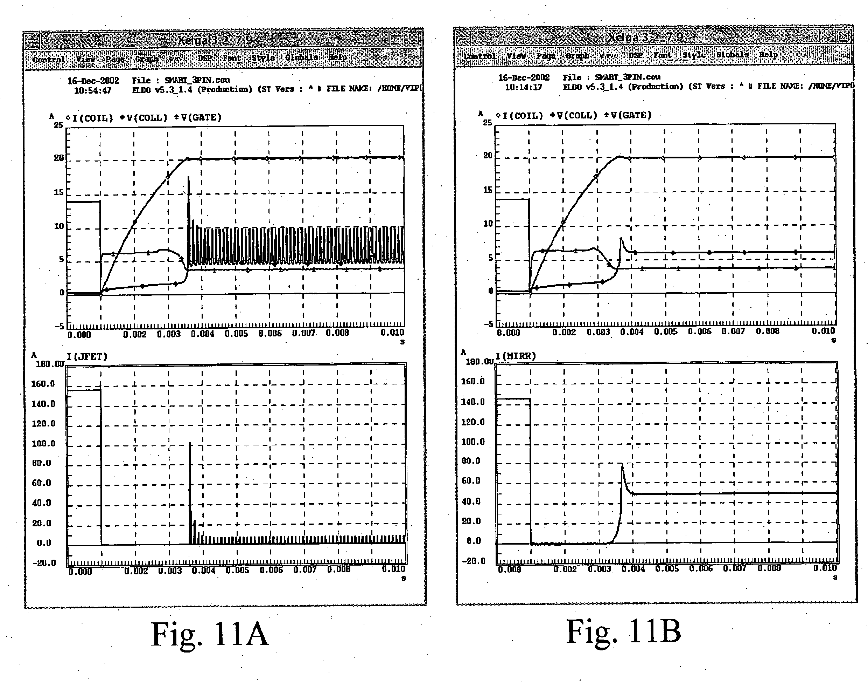

- Figures 11A and 11B show the trend of waveforms obtained by simulating said control circuit, according to the invention.

### Detailed description

With reference to these drawings, and particularly to the example of figure 9, a control circuit for a power transistor, for example an IGBT transistor, which has been advantageously modified according to the invention with respect to the known solution of figure 4 and by inserting a JFET transistor TR2 in place of the resistance Rf of figure 4, is shown with 20.

The circuit 20 is particularly, but not exclusively, suitable for applications in the automotive field for the electronic ignition in endothermic engines.

In figure 9 components and signals having the same structure and operation as the ones of figure 4 will keep the same reference numbers and acronyms.

In particular, the JFET transistor TR2 is connected, by means of a conduction terminal D thereof, particularly a Drain terminal, to a first conduction terminal, particularly a collector terminal C, of the IGBT transistor TR 1.

The JFET transistor TR2 is also connected, by means of another conduction terminal S, particularly a source terminal, to the control terminal, i.e. the gate terminal G1, of said IGBT transistor TR1.

The control terminal, i.e. the gate terminal G2, of said transistor TR2 is directly connected to a voltage reference, for example a ground GND.

Advantageously, according to the invention, said JFET transistor TR2 is inserted in said control circuit 20, integrated in the same structure of said IGBT transistor TR1, allowing a driver for said IGBT transistor to be realised, using a low voltage technology.

In particular, figure 7 schematically shows a sectional and enlarged-scale view of a structure of semiconductor-integrated electronic circuit 30 to realise in an integrated way the JFET transistor TR2 in the structure of said IGBT transistor TR1.

Said structure 30 comprises a silicon substrate 32 having a first conductivity type N and associated to a metal electrode 31, as well as a plurality of silicon wells 33, 34 having a second conductivity type P, realised above said substrate 32.

The well 33 is the body region of said JFET transistor TR2, while the well 34 is the active area of the JFET transistor.

The structure 30 is covered by an oxide layer 35 with contact openings 36, 37 and 38 in correspondence with the wells 33 and 34.

Metal layer ends 39 are overlapped to said layer 35 and in contact with said layer 32 through said opening 37, as well as with said well 33 through the opening 36 and with said well 34 through the opening 38.

Figure 7 also shows, overlapped, the circuit equivalents of said layer 32 and of said JFET transistor TR2 represented by a resistance Re and a resistance Rj respectively.

Figure 8 shows the typical curves of the circuit being implemented by the structure of figure 7.

As it can be noticed from the diagram of figure 8, said JFET transistor TR2 is always conducting for a gate voltage equal to zero Volt and the current I_{JFET} thereof decreases reverse-biasing the gate source junction, up to the pinch-off voltage value, equal to about -4V, for which said JFET transistor TR2 is completely inhibited.

With a low voltage technology it is thus possible to design control circuits of IGBT transistors such as said transistor TR1 which, in order to ensure the stability of the whole system, use a JFET transistor, in particular said JFET transistor TR2 is used as feedback resistance.

When the JFET transistor TR2 is directly connected between the first conduction terminal, the collector C, and the control terminal, the gate G1 of the IGBT transistor TR1, a real feedback of the collector voltage does not occur since the voltage between the gate G2 and the source S of the transistor TR2 is equal to the voltage between the gate G1 and the ground GND and it can extinguish the current IJFET with subsequent circuit instability.

Advantageously, according to the invention, in order to feedback the collector voltage, the circuit of figure 9 can be modified as in figure 10, wherein components and signals being already in figure 9 will keep the same labels as in figure 9.

In particular, a block A, located in the box, has been inserted in figure 10, through which the source terminal S of said JFET transistor TR2 is not directly connected to the gate G1 of the IGBT transistor TR1, but to the collector terminal of a first diode-connected bipolar transistor Q 1 of the NPN type, having the emitter terminal connected to the ground and being also connected through its base to the base terminal of a second bipolar transistor Q2 of the NPN type used as current mirror.

In this way the voltage between the gate terminal G2 and the source terminal S of said JFET transistor TR2, corresponding to the voltage drop between the base and the emitter of said first bipolar transistor Q 1 of the NPN type with opposite sign, is always lower in absolute value than the pinch-off voltage.

Moreover, this voltage is almost constant, and thus said second JFET transistor TR2 is forced to operate on a predetermined output feature, allowing a constant resistance value to be obtained in the ohmic area.

The collector terminal of said second bipolar transistor Q2 of the NPN type is connected to the collector terminal of a third bipolar transistor Q3 of the PNP type, being connected in turn, in a current mirror configuration, to a forth bipolar transistor Q4 of the PNP type.

The pairs of transistors Q1, Q2 and Q3, Q4 are substantially two current mirrors.

The collector current I_{MIRR} outputted by said forth bipolar transistor Q4 will then be equal to said current I_{JFET} supplied by said JFET transistor TR2.

By connecting the collector terminal of said forth bipolar transistor Q4 to said first gate terminal G1 of said IGBT transistor TR1, a feedback occurs from the collector terminal C, which is independent from the value of the gate voltage calculated in said gate terminal G1.

Figure 11a shows the results of the simulation of the circuit of figure 9 and figure 11b shows those related to the circuit of figure 10.

In figure 11a, it can be seen that, by using the JFET transistor TR2 located as the prior art resistance Rf, i.e. by directly connecting it between said collector terminal C and said gate terminal G1 of the IGBT transistor TR1, the feedback current I_{JFET} is void when the voltage of said gate terminal G1 increases, and oscillations thus arise on the collector voltage, being it impossible to stabilise the fed-back circuit.

Figure 11b relates to the simulation of the same circuit wherein the block A of figure 10 has been introduced.

In this case too, in the current limitation step, the voltage calculated on the gate terminal G1 of said IGBT transistor TR1 reaches about 4V, but said JFET transistor TR2 is not inhibited, since it always detects between the source terminal S and the gate terminal G2 a voltage being equal to the voltage calculated between the base and emitter terminals of said first bipolar transistor Q 1 of the NPN type.

The current I_{MIRR}, obtained by mirroring the current I_{JFET} calculated in the source terminal S of the JFET transistor TR2, being not void, thus allows the feedback from the collector voltage required for the circuit stabilisation to be obtained.

This feedback is also used to reduce the collector voltage overshoot occurring at the beginning of the current limitation step, when said IGBT transistor TR1 passes from the ohmic operation area thereof to the saturation area.

Advantages with respect to the prior art.

A remarkable advantage of the JFET structure integrated inside an IGBT transistor is that of providing, with circuits realised by using low voltage technologies, all those circuit solutions previously requiring the use of high voltage technologies.

In fact the prior art provided, for control circuits, for the realisation of high voltage structures being effective to directly interface with the IGBT transistor collector.

On the contrary, the proposed solution provides that the feedback from the IGBT transistor collector voltage is obtained by realising an interface locating in the same IGBT transistor structure the high voltage area, in order to obtain a low voltage signal which can be operated by means of circuits which can be realised in any of the low voltage technologies.

The proposed solution, of which a circuit embodiment can be seen in block A of figure 10, provides the realisation of an interface being capable to modify the feedback signal of the collector voltage, coming from the JFET transistor structure, to make it suitable for driving the IGBT transistor gate terminal G1.

This circuit forces the JFET transistor to operate at a constant voltage (Vgs) calculated between the gate terminal and the source terminal, so that said transistor can be used on a predetermined output feature.

Another embodiment of a control circuit for an IGBT transistor, using the resistance Rf of figure 4, is obtained by using a technology called ViPower.

Figure 5 shows an example of a possible exploitation of the ViPower technology to realise a control circuit for said IGBT transistor TR1, globally indicated with 18 in the figure, using said resistance Rf, globally indicated with 8 in the figure.

In particular, the integrated structure 8 is effective to implement, with the ViPower technology, a high voltage resistance.

The resistive structure 8 is integrated on a first semiconductor epitaxial layer 10 of a first conductivity type N, slightly doped (N-), located on a semiconductor substrate 9 of said first heavily doped conductivity type (N+); the resistive structure 8 comprised a plurality of buried and parallel regions 12, of a second conductivity type P, realised in the epitaxial layer 10.

The resistive structure 8 also comprises two opposite end regions 13, always having said second heavily doped conductivity type (P+), in contact with the two buried end regions 12. At least a region 13 is laterally separated from a region 15 having a first heavily doped conductivity type (N+) by means of a portion 14 of the epitaxial layer 10.

Said high voltage resistance being shown is capable to "throttle", considerably increasing the resistivity thereof, when the voltage at the ends exceeds a certain value, as shown in detail in the diagram of figure 6.

It can be noticed from this typical curve, realised by means of a curve tracer, that in the almost linear area thereof the resistance is used as feedback from the collector of the IGBT transistor TR1, in order to stabilise the system, while the feature thereof to pinch at high voltage is used when said IGBT transistor is turned off, since, when the collector voltage thereof increases, the current which can flow through the resistance cannot turn it on, as it would have happened instead with a linear-behaviour component.

The solution can be obtained by using also other high voltage technologies allowing a pinched resistance to be integrated.

On the contrary, the IGBT transistor 18 comprises a semiconductor substrate 16 of said second heavily doped conductivity type (P⁺⁺), realising the bipolar transistor conduction electrodes, a region 21 of said second heavily doped conductivity type (P⁺), called body region, realised in the first epitaxial layer 19 of said first slightly doped conductivity type (N-), while the driving terminal is realised in contact with the first epitaxial layer 19 itself.

The vertical MOS transistor comprises said body region 21 wherein a source region 23 of said first heavily doped conductivity type (N⁺), is integrated.

A gate region 24 completes the IGBT transistor 18; a side portion of the region 21, wherein the source region 23 is integrated, can be used as body region 21b for the IGBT transistor.

The resistance 8 is connected to the collector of the transistor 18 by placing the respective substrates 9 and 16 of the two dies on the same package frame 17, while the connection to the gate 24 of the transistor 18 is performed by means of an inner connection wire 25.

## Claims

1. A circuit (20) for dynamic control of a power transistor in applications for high voltage and of the type wherein a power transistor (TR1) has a conduction terminal (C) connected to a load and a control terminal (G1) receiving a driving signal from a driver block (4) activated by a trigger signal (Vin) received on a circuit input terminal (IN1), **characterised in that** it comprises a JFET component (TR2) inserted between the conduction (C) and control (G1) terminal of the power transistor (TR1) and equal to a resistance with non-linear feature, said JFET component (TR2) being a transistor having respective drain (D) and source (S) terminals connected to the conduction (C) and control (G1) terminals of said power transistor, as well as a gate terminal (G2) directly connected to a voltage reference (GND).

2. A circuit according to claim 1, **characterised in that** said JFET component (TR2) is monolithically integrated in the structure of said power transistor (TR1).

3. A circuit according to claim 1, **characterised in that** said JFET component (TR2) is a feedback resistance for the conduction terminal of said power transistor (TR1).

4. A circuit according to claim 1, **characterised in that** said JFET component (TR2) is forced to operate in a predetermined output feature in the ohmic area with a constant resistance value.

5. A circuit according to claim 1, **characterised in that** said JFET transistor (TR2) is associated to a circuit (A) adjusting the voltage drop between the gate (G2) and source (S) terminals of the JFET transistor to keep it lower than a pinch-off voltage.

6. A circuit according to claim 5, **characterised in that** said circuit (A) is inserted between the source (S) terminal of the JFET transistor (TR2) and the control terminal (G1) of the power transistor (TR1) and it comprises a pair of current mirrors to supply the same current of said JFET transistor.

7. A circuit according to claim 5, **characterised in that** said circuit (A) realises a feedback connection on said conduction terminal (C) of the power transistor (TR1) being independent from the voltage value on the control terminal (G1) of the same power transistor (TR1).

8. A circuit according to claim 1, **characterised in that** said JFET component (TR2) operates in a constant voltage drop (Vgs).

## Patentansprüche

1. Schaltung (20) für die dynamische Steuerung eines Leistungstransistors bei Anwendungen mit hoher Spannung, und zwar des Typs, bei dem ein Leistungstransistor (TR1) einen mit einer Last verbundenen Leitungsanschluss (C) sowie einen Steueranschluss (G1) aufweist, der ein Ansteuersignal von einem Treiberblock (4) erhält, der durch ein Auslösesignal (Vin) aktiviert wird, das an einem Schaltungseingangsanschluss (IN1) empfangen wird,
**dadurch gekennzeichnet, dass** sie eine JFET-Komponente (TR2) aufweist, die zwischen dem Leitungsanschluss (C) und dem Steueranschluss (G1) des Leistungstransistors (TR1) eingefügt ist und gleich einem Widerstand mit nichtlinearer Eigenschaft ist, wobei es sich bei der JFET-Komponente (TR2) um einen Transistor mit einem jeweiligen Drain-Anschluss (D) und Source-Anschluss (S) handelt, die mit dem Leitungsanschluss (C) und dem Steueranschluss (G1) des Leistungstransistors verbunden sind, sowie ferner einen Gateanschluss (G2) aufweist, der mit einer Referenzspannung (GND) direkt verbunden ist.

2. Schaltung nach Anspruch 1,
**dadurch gekennzeichnet, dass** die JFET-Komponente (TR2) in die Struktur des Leistungstransistors (TR1) monolithisch integriert ist.

3. Schaltung nach Anspruch 1,
**dadurch gekennzeichnet, dass** die JFET-Komponente (TR2) ein Rückkopplungswiderstand für den Leitungsanschluss des Leistungstransistors (TR1) ist.

4. Schaltung nach Anspruch 1,
**dadurch gekennzeichnet, dass** die JFET-Komponente (TR2) zwangsweise mit einer vorbestimmten Ausgangseigenschaft in dem ohmschen Bereich mit einem konstanten Widerstandswert betrieben wird.

5. Schaltung nach Anspruch 1,
**dadurch gekennzeichnet, dass** der JFET-Transistor (TR2) einer Schaltung (A) zugeordnet ist, die den Spannungsabfall zwischen dem Gateanschluss (G2) und dem Source-Anschluss (S) des JFET-Transistors einstellt, um diesen niedriger zu halten als eine Abschnürspannung.

6. Schaltung nach Anspruch 5,
**dadurch gekennzeichnet, dass** die Schaltung (A) zwischen dem Source-Anschluss (S) des JFET-Transistors (TR2) und dem Steueranschluss (G1) des Leistungstransistors (TR1) eingefügt ist und ein Paar Stromspiegel aufweist, um für eine Zufuhr des gleichen Stroms des JFET-Transistors zu sorgen.

7. Schaltung nach Anspruch 5,
**dadurch gekennzeichnet, dass** die Schaltung (A) eine Rückkopplungsverbindung an dem Leitungsanschluss (C) des Leistungstransistors (TR1) realisiert, die unabhängig von dem Spannungswert an dem Steueranschluss (G1) des gleichen Leistungstransistors (TR1) ist.

8. Schaltung nach Anspruch 1,
**dadurch gekennzeichnet, dass** die JFET-Komponente (TR2) mit einem konstanten Spannungsabfall (Vgs) arbeitet.

## Revendications

1. Circuit (20) destiné à une commande dynamique d'un transistor de puissance dans des applications de haute tension et du type où un transistor de puissance (TR1) comporte une borne de conduction (C) connectée à une charge et une borne de commande (G1) recevant un signal d'attaque provenant d'un bloc de circuit d'attaque (4) activé par un signal de déclenchement (Vin) reçu sur une borne d'entrée de circuit (IN1), **caractérisé en ce qu'**il comprend une composante de transistor JFET (TR2) insérée entre la borne de connexion (C) et la borne de commande (G1) du transistor de puissance (TR1) et égale à une résistance présentant une caractéristique non linéaire, ladite composante de transistor JFET (TR2) étant un transistor ayant des bornes de drain (D) et de source (S) respectives connectées aux bornes de conduction (C) et de commande (G1) dudit transistor de puissance, ainsi qu'une borne de grille (G2) directement connectée à une fréquence de tension (GND).

2. Circuit selon la revendication 1, **caractérisé en ce que** ladite composante de transistor JFET (TR2) est monolithiquement intégrée dans la structure dudit transistor de puissance (TR1).

3. Circuit selon la revendication 1, **caractérisé en ce que** ladite composante de transistor JFET (TR2) est une résistance de rétroaction pour la borne de conduction dudit transistor de puissance (TR1).

4. Circuit selon la revendication 1, **caractérisé en ce que** ladite composante de transistor JFET (TR2) est forcée à fonctionner dans une caractéristique de sortie prédéterminée dans la zone ohmique avec une valeur de résistance constante.

5. Circuit selon la revendication 1, **caractérisé en ce que** ledit transistor JFET (TR2) est associé à un circuit (A) réglant la chute de tension entre les bornes de grille (G2) et de source (S) du transistor JFET pour la maintenir inférieure à une tension de pincement.

6. Circuit selon la revendication 5, **caractérisé en ce que** ledit circuit (A) est inséré entre la borne de source (S) du transistor JFET (TR2) et la borne de commande (G1) du transistor de puissance (TR1) et il comprend une paire de miroirs de courant pour fournir le même courant dudit transistor JFET.

7. Circuit selon la revendication 5, **caractérisé en ce que** ledit circuit (A) réalise une connexion de rétroaction sur ladite borne de conduction (C) du transistor de puissance (TR1) qui est indépendante de la valeur de tension sur la borne de commande (G1) du même transistor de puissance (TR1).

8. Circuit selon la revendication 1, **caractérisé en ce que** ladite composante de transistor JFET (TR2) fonctionne suivant une chute de tension constante (Vgs).
